# FASCICULE DE BREVET EUROPEEN

(11) **EP 3 693 497 B1**
(45) Date de publication et mention de la délivrance du brevet: **30.03.2022**
(21) Numéro de dépôt: 20155730.3
(22) Date de dépôt: 05.02.2020
(51) Int. Cl.: C23C 30/00, C25D 5/48, H01J 23/00, H01J 5/10, C23C 18/16, C23C 18/42, C23C 18/48

(54) **REVÊTEMENT ANTI-MULTIPACTOR DÉPOSÉ SUR COMPOSANT MÉTALLIQUE RF OU MW, PROCÉDÉ DE RÉALISATION PAR TEXTURATION LASER D'UN TEL REVÊTEMENT**
ANTI-MULTIPAKTOR-BESCHICHTUNG AUF EINER RF- ODER MW-METALLKOMPONENTE, HERSTELLUNGSVERFAHREN DURCH LASERTEXTURIERUNG EINER SOLCHEN BESCHICHTUNG
ANTI-MULTIPACTOR COATING DEPOSITED ON RF OR MW METAL COMPONENT, METHOD FOR PRODUCING SUCH A COATING BY LASER TEXTURING

(30) Priorité: 11.02.2019 FR 1901338
(43) Date de publication de la demande: 12.08.2020
(73) Titulaire: Radiall, 93300 Aubervilliers (FR)
(72) Inventeur: CAILLAUD, Pauline, 38500 VOIRON (FR); JANOT, Fabrice, 38080 L'Isle d' Abeau (FR)
(74) Mandataire: Nony

(56) Documents cités:
- CN-A- 108 767 413
- US-A1- 2009 261 926
- SATTLER J M ET AL: "Modeling micro-porous surfaces for secondary electron emission control to suppress multipactor", JOURNAL OF APPLIED PHYSICS, AMERICAN INSTITUTE OF PHYSICS, US, vol. 122, no. 5, 7 août 2017 (2017-08-07), page 055304, XP012220692, ISSN: 0021-8979, DOI: 10.1063/1.4997465 [extrait le 2017-08-07]
- WANG RUI ET AL: "A novel method to improve the power capabilities of microwave components", 2013 EUROPEAN MICROWAVE INTEGRATED CIRCUIT CONFERENCE, EUROPEAN MICROWAVE ASSOCIATION, 6 octobre 2013 (2013-10-06), pages 456-459, XP032533845,
- NISTOR VALENTIN ET AL: "Multipactor suppression by micro-structured gold/silver coatings for space applications", APPLIED SURFACE SCIENCE, ELSEVIER, AMSTERDAM, NL, vol. 315, 20 mai 2014 (2014-05-20), pages 445-453, XP029057015, ISSN: 0169-4332, DOI: 10.1016/J.APSUSC.2014.05.049
- ZHAO WANQIN ET AL: "Ablation and morphological evolution of micro-holes in stainless steel with picosecond laser pulses", THE INTERNATIONAL JOURNAL OF ADVANCED MANUFACTURING TECHNOLOGY, SPRINGER, LONDON, vol. 80, no. 9, 24 April 2015 (2015-04-24) , pages 1713-1720, XP035536625, ISSN: 0268-3768, DOI: 10.1007/S00170-015-7145-8 [retrieved on 2015-04-24]
- JANDELEIT J ET AL: "Fundamental investigations of micromachining by nano- and picosecond laser radiation", APPLIED SURFACE SCIENCE, vol. 127-129, 1 May 1998 (1998-05-01), pages 885-891, XP055842462, AMSTERDAM, NL ISSN: 0169-4332, DOI: 10.1016/S0169-4332(97)00762-9 Retrieved from the Internet: URL:https://www.sciencedirect.com/science/ article/pii/S0169433297007629/pdfft?md5=34 5f3906131c44c97d16283c95e064e1&pid=1-s2.0- S0169433297007629-main.pdf>

## Description

### Domaine technique

La présente invention a pour objet un revêtement anti-multipactor déposé sur un composant métallique et son procédé de réalisation.

Par « revêtement anti-multipactor », on entend ici et dans le cadre de l'invention, un revêtement dont la fonction est de supprimer à tout le moins réduire très fortement l'effet dit « multipactor ».

L'invention s'applique à tout composant d'un dispositif destiné à assurer la transmission et/ou réception de signaux radio-fréquences (RF) ou dans la gamme des micro-ondes (MW) pour des télécommunications spatiales, tels par exemple des connecteurs, des commutateurs.

L'invention peut également s'appliquer au domaine nucléaire, et de façon générale à toute application où il existe un risque d'effet multipactor.

L'invention peut s'appliquer en particulier aux contacts de connecteurs, de commutateurs coaxiaux ou en guide d'ondes, aux antennes.

### Technique antérieure

L'effet multipactor est un phénomène de décharge électronique résonante dans le vide, qui se produit lorsque des électrons primaires sous l'effet d'un champ électrique alternatif viennent arracher des électrons secondaires à la paroi d'un composant radioélectrique, tel qu'un guide d'onde ou un contact.

Ces électrons secondaires émis sont accélérés à leur tour par le champ électrique alternatif appliqué, et viennent également arracher de nouveaux électrons secondaires, sur la paroi opposée du composant.

Sous certaines conditions, en particulier sous vide spatial, un effet multiplicateur ou d'avalanche se met en place, conduisant à une décharge électronique ou un claquage dans le gaz résiduel à faible pression, qui peut endommager les structures.

En particulier, dans les dispositifs de transmission de grande puissance, un effet multipactor peut se produire dans la connectique ou instrumentation spatiale de micro-ondes (MW) et de radiofréquences (RF), comme dans les structures de grands systèmes de plasma toroïdal thermo-nucléaire.

Dans les accélérateurs de particules, qui utilisent une grande variété de géométries et fonctionnent dans une fréquence allant du MHz à des dizaines de GHz, l'effet multipactor limite la puissance maximale pouvant être transmise dans ces appareils de forte puissance qui fonctionnent dans des conditions de vide.

De fait, dans tous les dispositifs de connectique de grande puissance RF destinés à aller dans l'espace, les grands accélérateurs de particules, les klystrons et autres tubes à vide de haute puissance RF, l'effet multipactor peut avoir un impact néfaste important.

Une solution connue pour supprimer à tout le moins réduire au maximum cet effet multipactor consiste à déposer un revêtement adapté sur les surfaces des pièces concernées.

Un tel revêtement, dit anti-multipactor, doit présenter une conductivité électrique surfacique suffisante, afin de minimiser les pertes RF, une grande résistance à l'exposition à l'air et une faible capacité à réémettre des électrons secondaires.

Ce dernier point est connu sous la dénomination de rendement d'électrons secondaires (SEY acronyme anglais pour « *Secondary Electron Yield »).*

Ainsi, un revêtement anti-multipactor doit réduire au maximum le SEY.

Une des solutions consiste à créer une surface irrégulière et non plane au niveau des zones qui sont susceptibles d'émettre ces électrons secondaires. Ces électrons sont alors piégés en partie dans ce relief irrégulier.

La demande de brevet US2017/0292190 propose un revêtement anti-multipactor déposé sur un substrat métallique par voie chimique qui nécessite notamment l'utilisation d'un acide pour la mise en œuvre une étape de gravure. Le revêtement divulgué présente des performances qui sont loin d'être parfaites. Par ailleurs, le procédé chimique de gravure est réalisé par immersion dans un ou plusieurs bains chimiques et il ne permet pas d'une part de pouvoir réellement, ou au prix de mesures très contraignantes, des revêtements localisés uniquement dans certaines zones de composants. D'autre part il ne permet pas de mettre en œ uvre un revêtement à base d'or, un des métaux des plus inertes chimiquement, mais qui consiste pourtant un des candidats idéaux pour l'effet anti-multipactor recherché. En outre, le procédé peut générer des revêtements dont la texture n'est pas uniforme, et qui peut laisser des zones mal texturées et donc qui peut être source d'une augmentation du SEY.

La publication [1] décrit la réalisation de micro-pores par un procédé mixte galvanoplastie/photolithographie dans une couche d'or réalisé sur un substrat en silicium revêtu d'une couche en SiN.

La publication [2] divulgue la réalisation par photolithographie d'un composant RF (filtre à pont dans la bande K) comprenant un substrat en aluminium sur lequel est déposé par photolithographie un revêtement en Ag.

Les procédés des publications [1] et [2] génèrent des formes simples de trous dont il est impossible de maîtriser la forme de parois. Également, ces procédés ne peuvent réaliser des pores sur des surfaces bi-dimensionnelles, et ne sont donc pas adaptés pour des produits, tels que des composants RF, dont les surfaces sont en trois dimensions avec notamment des parois contiguës, perpendiculaires entre elles. En outre, ces procédés par photolithographie ne peuvent être mis en œuvre pour l'intérieur ou l'extérieur de surfaces cylindriques ou à fort rayon de courbure et/ou de grandes tailles. Enfin ces procédés présentent des inconvénients intrinsèques à la photolithographie à savoir d'une part la nécessité d'un environnement spécifique en salle blanche et d'autre part l'utilisation de résine organique peu recommandée pour des applications spatiales, et nécessitant des process complémentaires et lourds de nettoyage poussé pour éviter les risques de dégazage.

Par ailleurs, la demande de brevet CN108767413 divulgue des composants MW destinés au spatial dont la surface est ablatée par un laser pour supprimer le phénomène de micro-décharge. La topographie prévue est de l'ordre de plusieurs centaines de µm, ce qui ne permet pas un effet anti-multipactor optimal pour les applications actuelles.

La publication *«Ablation and morphological evolution of micro-holes in stainless steel with picosecond laser pulses* », Zhao et al., The International Journal of Advanced Manufacturing Technology, vol. 80 no. 9, 24 avril 2015, décrit l'effet de lasers femtosecondes à nanosecondes sur l'usinage par laser dans des applications industrielles, en particulier pour l'acier.

Il existe donc un besoin d'améliorer les revêtements anti-multipactor et leur procédé de réalisation, notamment pour obtenir un faible SEY, une conductivité électrique surfacique suffisante, une grande résistance à l'exposition à l'air, et ce, afin de conserver au mieux les performances électriques de transmission des signaux RF par des composants métalliques qui en sont munis.

Le but de l'invention est de résoudre au moins partiellement ce besoin.

### Exposé de l'invention

Pour ce faire, l'invention a pour objet un procédé de réalisation d'un revêtement anti-multipactor sur un substrat métallique, comprenant les étapes suivantes :
(a) dépôt d'un revêtement en un matériau constitutif choisi les métaux de la colonne 10 ou colonne 11 du tableau de Mendeleïev ou un alliage de ces métaux, sur au moins une partie de surface du substrat métallique,
(b) traitement par laser du revêtement déposé selon l'étape (a), de sorte à obtenir une texturation du revêtement déposé, avec un ou plusieurs motifs répétés à intervalles réguliers de cavités, le pas d'intervalle entre deux cavités adjacentes étant compris entre 0 et 100 µm.

Le diamètre d'ouverture de chaque cavité peut être compris entre 2 et 50µm, de préférence entre 2 et 30 µm.

Le cas échéant, au préalable de l'étape (a), le procédé peut comprendre une étape de dépôt d'une couche d'accroche du revêtement.

Avantageusement, le matériau constitutif du revêtement déposé selon l'étape (a) est choisi parmi l'or, l'argent, un alliage d'argent, un alliage d'or de préférence, un alliage or-nickel ou or-cobalt.

Selon une variante de réalisation avantageuse, l'étape (b) est réalisée au moyen d'un laser femtoseconde. On rappelle ici qu'à l'inverse d'un laser conventionnel, qui produit habituellement un rayonnement continu, un laser femtoseconde produit des flashs très brefs de lumière, soit des impulsions. Chaque impulsion dure de préférence de quelques fs à 100 fs, 1fs étant égal à 10⁻¹⁵s.

Un des avantages d'un laser femtoseconde est d'avoir une zone affectée thermiquement, par son impact qui est très faible. En outre, un laser femtoseconde permet d'obtenir des motifs de cavités parfaitement répétitifs à intervalles réguliers, ce que l'on recherche dans le cadre de l'invention.

De préférence, l'étape (a) est réalisée selon une technique de traitement de surface électrochimique (revêtement chimique ou électrolytique).

Selon une variante de réalisation avantageuse, au préalable de l'étape (a), on réalise le revêtement d'au moins une couche mince déposée selon une technique de dépôt physique en phase vapeur (PVD) sur le substrat métallique.

Avantageusement, la couche mince déposée au préalable est en or.

L'invention a également pour objet l'utilisation d'un composant radiofréquence (RF) ou micro-ondes (MW), notamment pour la transmission de signaux depuis ou vers un satellite, dont au moins une partie de la surface de la partie active est constituée par un substrat métallique revêtu du revêtement anti-multipactor selon le procédé décrit précédemment.

Le composant obtenu peut constituer un connecteur coaxial RF, ou un commutateur RF de type coaxial ou un guide d'onde. Il peut par exemple s'agir de commutateurs en guides d'ondes en émission et/ou réception dans les bandes P, S, L, C ou X ou encore de commutateurs coaxiaux en émission et/ou réception dans toutes les bandes de fréquence du spectre électromagnétique.

Ainsi, l'invention consiste essentiellement en un revêtement anti-multipactor, de préférence en or ou en argent ou un alliage de ces métaux, qui est texturé par ablation laser qui permet de créer des cavités de géométrie calibrée et répétée de manière régulière sur la partie de surface du composant métallique qui en est muni selon un pas d'intervalles entre 0 et 100 µm.

Les cavités agissent comme des pièges à électrons primaires très efficaces, ce qui permet d'avoir un SEY réduit. En plus, le fait d'avoir ces motifs de cavités répétés à intervalles réguliers implique une texture de revêtement uniforme, ce qui favorise aussi un SEY réduit. La distance réduite entre cavités limite fortement l'effet multipactor, prépondérant sur les surfaces en deux dimensions.

Grâce au revêtement anti-multipactor selon l'invention, les performances en termes de puissance de transmission des signaux HF ou MW peuvent être considérablement améliorées comparativement à un revêtement métallique conducteur, notamment en or ou en argent réalisé uniquement par dépôt selon une technique de traitement de surface de type dépôt électrochimique (chimique ou électrolytique) par exemple, sans pour autant dégrader de façon notable les performances RF ou MW, tels que le niveau de pertes RF lors de la transmission d'un signal RF.

De plus, l'utilisation d'un laser pour texturer la surface du revêtement déposé, permet de maitriser aisément et d'ajuster le type de texturation (taille et profondeur des cavités, périodicité du motif) et de traiter seulement localement les surfaces du substrat, susceptibles d'émettre des électrons secondaires, à la différence d'une gravure chimique selon l'état de l'art qui est appliquée dans un bain dans lequel est immergée la pièce à traiter.

En outre, la texturation par ablation laser permet de créer des cavités dont la forme est parfaitement cylindrique et en sus des cavités, des microcavités sur les parois de ces dernières qui ont une forme en éponge. L'obtention de ces formes est très favorable à l'effet anti-multipactor.

De plus, la texturation par ablation laser selon l'invention permet d'obtenir des profondeurs de cavités qui sont faibles, contrairement aux procédés selon l'art antérieur, ce qui est avantageux car la consommation des métaux précieux en surface, notamment l'or, et donc le coût afférent peuvent être réduits.

Enfin, la texturation par laser permet de modifier aisément la surface d'un revêtement d'or, ce qui est difficile voire impossible par attaque chimique.

D'autres avantages et caractéristiques de l'invention ressortiront mieux à la lecture de la description détaillée d'exemples de mise en œuvre de l'invention faite à titre illustratif et non limitatif en référence aux figures suivantes.

### Brève description des dessins

[Fig 1] est une reproduction photographique d'un revêtement anti-multipactor conforme à l'invention;
[Fig 2A] est une vue schématique de dessus de motifs répétés de cavités d'un revêtement anti-multipactor conforme à l'invention;
[Fig 2B] est une vue schématique en coupe longitudinale d'une cavité d'un revêtement anti-multipactor conforme à l'invention;
[Fig 3] est une visualisation, obtenue par microscope confocal à balayage laser 3D de la topographie d'un revêtement anti-multipactor à motifs répétés à intervalles réguliers de cavités conforme à l'invention;
[Fig 4] est une vue en perspective d'un connecteur coaxial de type TNC mis en œuvre pour tester un revêtement anti-multipactor selon l'invention;
[Fig 5] est une vue en perspective d'une douille mise en œuvre pour tester un revêtement anti-multipactor selon l'invention;
[Fig 6] est une vue en perspective d'une demi-coquille mise en œuvre pour tester un revêtement anti-multipactor selon l'invention;
[Fig 7] est une vue en perspective d'un système de connexion comprenant deux connecteurs TNC tels que montrés en figure 4 entre lesquels une douille de connexion selon la figure 5 est connectée et entourée de deux demi-coquilles selon la figure 6, l'extérieur de la douille et l'intérieur des demi-coquilles étant recouverte d'un revêtement anti-multipactor en argent conforme à l'invention;
[Fig 8] est une vue en perspective du système de connexion selon la figure 7 tels qu'assemblé;

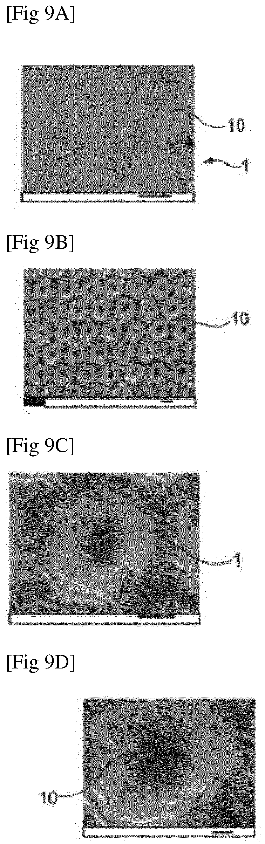

[Fig 9A] est une vue d'un microscope à balayage électronique (MEB) avec un grossissement x 250 d'un revêtement anti-multipactor en argent selon l'invention qui recouvre l'extérieur de la douille et l'intérieur des demi-coquilles;
[Fig 9B] est une vue d'un microscope à balayage électronique (MEB) avec un grossissement x 1000 d'un revêtement anti-multipactor en argent selon l'invention qui recouvre l'extérieur de la douille et l'intérieur des demi-coquilles;
[Fig 9C] est une vue d'un microscope à balayage électronique (MEB) avec un grossissement X 5000 d'un revêtement anti-multipactor en argent selon l'invention qui recouvre l'extérieur de la douille et l'intérieur des demi-coquilles, ce grossissement permettant de visualiser une cavité;
[Fig 9D] est une vue d'un microscope à balayage électronique (MEB) avec un grossissement x7500 d'un revêtement anti-multipactor en argent selon l'invention qui recouvre l'extérieur de la douille et l'intérieur des demi-coquilles, ce grossissement permettant de voir avec plus de précision la cavité de la figure 9C;

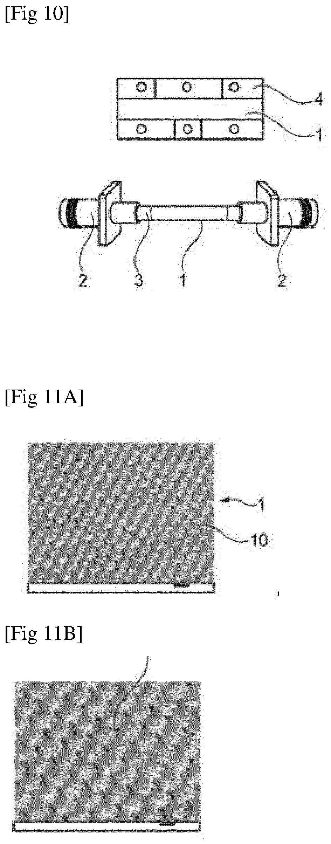

[Fig 10] est une vue en perspective d'un système de connexion comprenant deux connecteurs TNC tels que montrés en figure 4 entre lesquels une douille de connexion selon la figure 5 est connectée et entourée de deux demi-coquilles selon la figure 6, l'extérieur de la douille et l'intérieur des demi-coquilles étant recouverte d'un revêtement anti-multipactor en or conforme à l'invention;
[Fig 11A] est une vue d'un microscope à balayage électronique (MEB) avec un grossissement x550 d'un revêtement anti-multipactor en or selon l'invention qui recouvre l'extérieur de la douille et l'intérieur des demi-coquilles;
[Fig 11B] est une vue d'un microscope à balayage électronique (MEB) avec un grossissement x1000 d'un revêtement anti-multipactor en or selon l'invention qui recouvre l'extérieur de la douille et l'intérieur des demi-coquilles;
[Fig 11C] est une vue d'un microscope à balayage électronique (MEB) avec un grossissement x6000 d'un revêtement anti-multipactor en or selon l'invention qui recouvre l'extérieur de la douille et l'intérieur des demi-coquilles, ce grossissement permettant de visualiser une cavité;
[Fig 11D] est une vue d'un microscope à balayage électronique (MEB) avec un grossissement x7500 d'un revêtement anti-multipactor en or selon l'invention qui recouvre l'extérieur de la douille et l'intérieur des demi-coquilles, ce grossissement permettant de voir avec plus de précision la cavité de la figure 11C;
[Fig 12] est un graphe sous forme d'histogrammes montrant le gain en puissance de transmission apporté par un revêtement anti-multipactor en argent et en or selon l'invention comparativement à un revêtement respectivement en argent et en or selon l'état de l'art, obtenu uniquement par traitement de surface électrochimique, sans texturation.

### Description détaillée

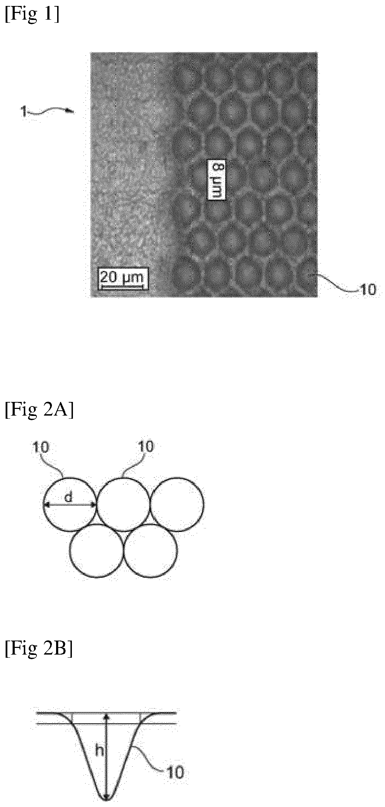

On a illustré à la figure 1, un revêtement anti-multipactor, globalement désigné par la référence 1, selon l'invention.

Ce revêtement 1 est en argent, or ou un alliage de l'un ou l'autre de ces métaux et sa texture comprend un ou plusieurs motifs répétés, à intervalles réguliers de cavités 10.

Une schématisation de motifs répétés et de cavités 10 est montré en figures 2A à 2B : les cavités 10 sont sensiblement jointives et ont chacune une ouverture circulaire et une forme générale en coupe substantiellement selon une gaussienne. A titre d'exemple indicatif, le diamètre unitaire des cavités 10 est de l'ordre de 20 µm et leur profondeur (hauteur) h est de l'ordre de 4 µm.

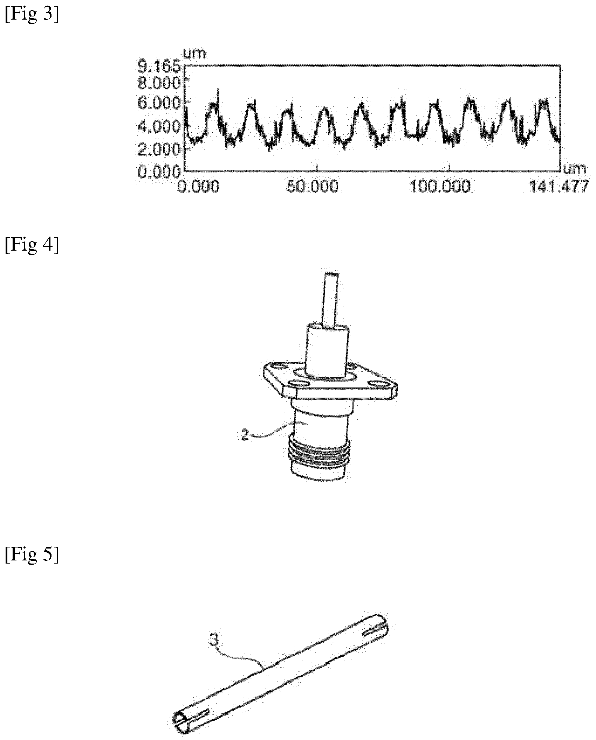

La topographie répétitive à intervalles réguliers de ces cavités 10 est bien visible en figure 3.

Pour obtenir le revêtement anti-multipactor 1 selon l'invention sur au moins une partie de surface d'un composant métallique RF ou MW, les inventeurs ont procédé de la manière suivante.

Etape a): On réalise un dépôt par traitement de surface de type dépôt électrochimique par exemple d'un revêtement en or ou en argent, ou en un alliage de l'un ou l'autre de ces métaux, sélectivement sur la surface concernée du composant métallique.

Ce dépôt est de l'ordre de quelques µm, voire quelques dizaines de µm. Par exemple, l'épaisseur de dépôt peut être comprise entre 1 et 15µm pour l'argent et 1 et 7µm pour l'or pur.

Etape b): on effectue un traitement par laser du revêtement déposé, de sorte à obtenir une texturation du revêtement déposé, avec un ou plusieurs motifs répétés à intervalles réguliers de cavités.

Le laser utilisé est de préférence un laser femtoseconde. Chaque cavité 10 est créée par une impulsion produite par le laser, d'une durée de quelques fs à 100 fs.

Pour prouver l'efficacité du revêtement anti-multipactor 1 selon l'invention, les inventeurs ont réalisé des essais sur un véhicule de test RF, dont une partie des composants métalliques est revêtue dudit revêtement.

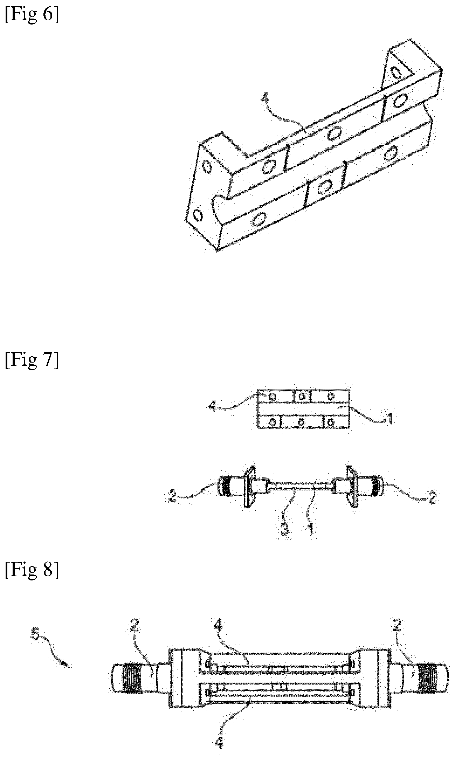

Le système de connexion utilisé 5 lors des essais comprend deux connecteurs coaxiaux 4 de type TNC, tels que montrés en figure 4, entre lesquels une douille en 3 montrée en figure 5 est connectée et autour de laquelle deux demi-coquilles 4 comme selon la figure 6 sont assemblées en définissant un espace annulaire autour.

Le système de connexion 5 assemblé et en configuration de fonctionnement est montré en figure 8.

Dans chacun des exemples considérés ci-après, les conditions des essais ont été les suivantes :
- douille 3 en cuivre béryllium (CuBe₂) et demi-coquille 4 en aluminium;
- fréquence du signal transmis par le système de connexion 5 : 1GHz;
- espace annulaire entre l'extérieur de la douille 3 et l'intérieur du cylindre défini par les deux demi-coquilles 4 assemblées: 2mm;
- puissance de transmission du signal: jusqu'à obtenir la décharge multipactor.

Exemple 1: L'extérieur de la douille 3 et l'intérieur des demi-coquilles 4 est revêtu d'un revêtement anti-multipactor 1 en argent et texturé conformément à l'invention, i.e. selon les étapes a) et b) du procédé décrit ci-dessus.

Exemple 1 comparatif: L'extérieur de la douille 3 et l'intérieur des demi-coquilles 4 est revêtu d'un revêtement 1 en argent mais sans aucune texturation, i.e. uniquement selon l'étape a) du procédé décrit ci-dessus.

Exemple 2: L'extérieur de la douille 3 et l'intérieur des demi-coquilles 4 est revêtu d'un revêtement anti-multipactor 2 en or et texturé conformément à l'invention, i.e. selon les étapes a) et b) du procédé décrit ci-dessus.

Exemple 2 comparatif: L'extérieur de la douille 3 et l'intérieur des demi-coquilles 4 est revêtu d'un revêtement 2 en or mais sans aucune texturation, i.e. uniquement selon l'étape a) du procédé décrit ci-dessus.

Exemple 3 comparatif : la douille 3 et les demi-coquilles 4 sont dépourvues de revêtement.

Les mesures de puissance du signal ont été faites selon la norme citée en référence ci-après.

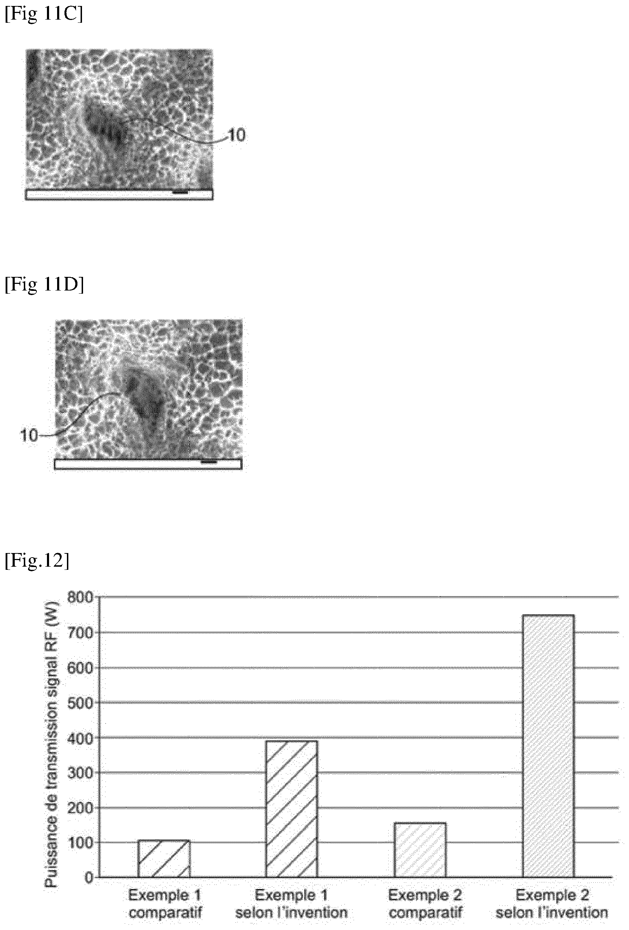

Les résultats des essais sont montrés sur la figure 12 et résumés dans le tableau 1 ci-dessous.

**[Tableau 1]**

| **Exemple** | **Puissance (W)** |
|---|---|
| Exemple 1 | 390 |
| Exemple 1 comparatif | 105 |
| Exemple 2 | 750 |
| Exemple 2 comparatif | 153 |
| Exemple 3 | 80 |

On constate que le meilleur résultat est obtenu avec un revêtement 1 en or texturé selon l'invention, avec un gain d'un facteur de l'ordre de 4,9 par rapport à un revêtement uniquement plaqué en or, ce qui est déjà considérable, et un gain d'un facteur de l'ordre de 9,38 comparativement à des composants métalliques sans revêtement, ce qui est très important.

Un revêtement 1 en argent texturé selon l'invention amène quant à lui un gain avec un facteur d'environ 2,95 par rapport à un revêtement uniquement plaqué en argent.

D'autres variantes et avantages de l'invention peuvent être réalisés sans pour autant sortir du cadre de l'invention.

Par exemple, si dans l'exemple illustré, le revêtement anti-multipactor selon l'invention est réalisé sur une douille formant un contact central d'une connectique RF, l'invention s'applique également à toute autre partie électriquement conductrice d'un dispositif RF ou MW, notamment pour transmission de puissance élevée, d'un commutateur, tel qu'un commutateur coaxial ou un commutateur en guide d'ondes.

L'invention n'est pas limitée aux exemples qui viennent d'être décrits ; on peut notamment combiner entre elles des caractéristiques des exemples illustrés au sein de variantes non illustrées.

### Liste des documents cités

1. Sattler et al. « Modeling micro-porous surfaces for secondary electron emission control to suppress multipactor », Journal of Applied Physics, American Institute of Physics, Vo1.122, N°5, 7 Août 2017.
2. Wang et al. « A novel method to improve the power capabilities of microwave components », 2013 European Microwave Integrated Circuit Conference; European Microwave Association, 6 Octobre 2013.
3. ECSS-E-20-01A (REV-1), SPACE ENGINEERING: MULTIPACTION DESIGN AND TEST (01-MAR-2013).

## Revendications

1. Procédé de réalisation d'un revêtement anti-multipactor sur un substrat métallique, comprenant les étapes suivantes:
(a) dépôt d'un revêtement en un matériau constitutif choisi parmi les métaux de la colonne 10 ou colonne 11 du tableau de Mendeleïev ou un alliage de ces métaux sur au moins une partie de surface du substrat métallique,
(b) traitement par laser du revêtement déposé selon l'étape (a), de sorte à obtenir une texturation du revêtement déposé, avec un ou plusieurs motifs répétés à intervalles réguliers de cavités, le pas d'intervalle entre deux cavités adjacentes étant compris entre 0 et 100 µm.

2. Procédé de réalisation selon la revendication 1, comprenant, au préalable de l'étape (a), une étape de dépôt d'une couche d'accroche du revêtement.

3. Procédé de réalisation selon la revendication 1 ou 2, le matériau constitutif du revêtement déposé selon l'étape (a) étant choisi parmi l'or, l'argent, un alliage d'argent, un alliage d'or de préférence, un alliage or-nickel ou or-cobalt.

4. Procédé de réalisation selon l'une des revendications 1 à 3, l'étape (b) étant réalisée au moyen d'un laser femtoseconde.

5. Procédé de réalisation selon l'une des revendications 1 à 4, l'étape (a) étant réalisée selon une technique de traitement de surface électrochimique.

6. Procédé de réalisation selon l'une des revendications 1 à 5, selon laquelle le diamètre d'ouverture de chaque cavité étant compris entre 2 et 50µm, de préférence entre 2 et 30 µm·

7. Procédé de réalisation selon l'une des revendications 1 à 6, selon lequel au préalable de l'étape (a) on réalise le revêtement d'au moins une couche mince déposée selon une technique de dépôt physique en phase vapeur (PVD) sur le substrat métallique.

8. Procédé de réalisation selon la revendication 7, la couche mince déposée au préalable étant en or.

9. Composant radiofréquence (RF) ou micro-ondes (MW) dont au moins une partie de la surface de la partie active est constituée par un substrat métallique revêtu du revêtement anti-multipactor selon le procédé de l'une des revendications précédentes.

10. Composant selon la revendication 9, constituant un connecteur coaxial RF, ou un commutateur RF de type coaxial ou un guide d'onde.

11. Utilisation d'un composant RF ou MW selon l'une des revendications 8 ou 9 pour la transmission de signaux depuis ou vers un satellite.

## Patentansprüche

1. Verfahren zur Herstellung einer Anti-Multipaktor-Beschichtung auf einem Metallsubstrat, umfassend die folgenden Schritte:
(a) Aufbringen einer Beschichtung aus einem Material, das unter den Metallen der Spalte 10 oder Spalte 11 des Periodensystems oder einer Legierung dieser Metalle gewählt ist, auf mindestens einen Teil der Oberfläche des Metallsubstrats,
(b) Behandeln der gemäß Schritt (a) aufgebrachten Beschichtung mit Laser, so dass eine Texturierung der aufgebrachten Beschichtung mit einem in regelmäßigen Abständen wiederholten Muster aus Kavitäten erhalten wird, wobei der Intervallschritt zwischen zwei benachbarten Kavitäten zwischen 0 und 100 µm beträgt.

2. Herstellungsverfahren nach Anspruch 1, umfassend, vor dem Schritt (a), einen Schritt des Aufbringens einer Haftvermittlerschicht für die Beschichtung.

3. Herstellungsverfahren nach Anspruch 1 oder 2, wobei das Material der gemäß Schritt (a) aufgebrachten Beschichtung unter Gold, Silber, einer Silberlegierung, bevorzugt einer Goldlegierung, einer Gold-Nickel- oder Gold-Cobalt-Legierung gewählt ist.

4. Herstellungsverfahren nach einem der Ansprüche 1 bis 3, wobei der Schritt (b) mittels eines Femtosekundenlasers ausgeführt wird.

5. Herstellungsverfahren nach einem der Ansprüche 1 bis 4, wobei der Schritt (a) mit einer elektrochemischen Oberflächenbehandlungstechnik ausgeführt wird.

6. Herstellungsverfahren nach einem der Ansprüche 1 bis 5, gemäß dem der Öffnungsdurchmesser jeder Kavität zwischen 2 und 50 µm, bevorzugt zwischen 2 und 30 µm beträgt.

7. Herstellungsverfahren nach einem der Ansprüche 1 bis 6, gemäß dem vor dem Schritt (a) die Beschichtung mit mindestens einer dünnen Schicht ausgeführt wird, die mit einer Technik der physikalischen Gasphasenabscheidung (PVD) auf das Metallsubstrat aufgebracht wird.

8. Herstellungsverfahren nach Anspruch 7, wobei die zuvor aufgebrachte dünne Schicht aus Gold ist.

9. Hochfrequenzkomponente (HF) oder Mikrowellenkomponente (MW), bei der mindestens ein Teil der Oberfläche des aktiven Teils aus einem Metallsubstrat besteht, das mit der Anti-Multipaktor-Beschichtung nach dem Verfahren eines der vorhergehenden Ansprüche beschichtet ist.

10. Komponente nach Anspruch 9, die einen HF-Koaxialsteckverbinder oder einen HF-Schalter vom koaxialen Typ oder einen Wellenleiter bildet.

11. Verwendung einer HF- oder MW-Komponente nach einem der Ansprüche 8 oder 9 zur Übertragung von Signalen von oder zu einem Satelliten.

## Claims

1. Method for producing an anti-multipactor coating on a metal substrate, comprising the following steps:
a) depositing a coating of a constituent material chosen from among the metals of group 10 or group 11 of the periodic table, or an alloy of these metals, on at least part of the surface of the metal substrate,
b) laser-treating the coating deposited in step a), so as to texturize the deposited coating, with one or more patterns repeated at regular cavity intervals, the interval pitch between two adjacent cavities being in the range between 0 and 100 µm.

2. Production method according to Claim 1, comprising, prior to step a), a step of depositing a coating tie layer.

3. Production method according to Claim 1 or 2, the constituent material of the coating deposited in step a) being chosen from among gold, silver, an alloy of silver, preferably an alloy of gold, a gold-nickel or gold-cobalt alloy.

4. Production method according to one of Claims 1 to 3, step b) being carried out by means of a femtosecond laser.

5. Production method according to one of Claims 1 to 4, step a) being carried out according to an electrochemical surface treatment technique.

6. Production method according to one of Claims 1 to 5, in which the opening diameter of each cavity is in the range between 2 and 50 µm, preferably between 2 and 30 µm.

7. Production method according to one of Claims 1 to 6, in which, prior to step a), the coating of at least one thin layer is carried out, which layer is deposited according to a physical vapour deposition (PVD) technique on the metal substrate.

8. Production method according to Claim 7, the thin layer deposited beforehand being a gold layer.

9. Radiofrequency (RF) or microwave (MW) component, at least part of the surface of the active part of which is composed of a metal substrate coated with the anti-multipactor coating according to the method of one of the preceding claims.

10. Component according to Claim 9, forming an RF coaxial connector, or a coaxial-type RF switch or a waveguide.

11. Use of an RF or MW component according to either one of Claims 8 and 9 for the transmission of signals from or to a satellite.
